(19) Europäisches Patentamt
European Patent Office
Office européen des brevets

(11) **EP 3 728 703 B1**

(12) **FASCICULE DE BREVET EUROPEEN**

(45) Date de publication et mention de la délivrance du brevet:
**09.11.2022 Bulletin 2022/45**

(21) Numéro de dépôt: **18826398.2**

(22) Date de dépôt: **24.12.2018**

(51) Classification Internationale des Brevets (IPC):
**C30B 25/18** (2006.01)   **C30B 29/40** (2006.01)

(52) Classification Coopérative des Brevets (CPC):
**C30B 25/183; C30B 29/403;** H01L 33/32

(86) Numéro de dépôt international:
**PCT/EP2018/086865**

(87) Numéro de publication internationale:
**WO 2019/122461 (27.06.2019 Gazette 2019/26)**

(54) **PROCÉDÉ PERMETTANT D'OBTENTION D'UNE COUCHE DE NITRURE**

VERFAHREN ZUR HERSTELLUNG EINER NITRIDSCHICHT

PROCESS FOR OBTAINING A NITRIDE LAYER

(84) Etats contractants désignés:
AL AT BE BG CH CY CZ DE DK EE ES FI FR GB GR HR HU IE IS IT LI LT LU LV MC MK MT NL NO PL PT RO RS SE SI SK SM TR

(30) Priorité: **22.12.2017 FR 1763186**

(43) Date de publication de la demande:
**28.10.2020 Bulletin 2020/44**

(73) Titulaires:
• **Commissariat à l'Energie Atomique et aux Energies Alternatives**
**75015 Paris (FR)**
• **Centre National de la Recherche Scientifique**
**75016 Paris (FR)**

(72) Inventeurs:
• **FEUILLET, Guy**
**38410 SAINT-MARTIN D'URIAGE (FR)**
• **ALLOING, Blandine**
**06560 VALBONNE (FR)**
• **BRANDLI, Virginie**
**06560 VALBONNE (FR)**
• **MATHIEU, Benoit**
**38000 GRENOBLE (FR)**
• **ZUNIGA PEREZ, Jesus**
**06410 BIOT (FR)**

(74) Mandataire: **Hautier, Nicolas**
**Cabinet Hautier**
**20, rue de la Liberté**
**06000 Nice (FR)**

(56) Documents cités:
**US-A1- 2010 087 049     US-A1- 2010 109 126**
**US-A1- 2012 119 218**

• **ZUBIA D ET AL: "Nanoheteroepitaxial growth of GaN on Si by organometallic vapor phase epitaxy", APPLIED PHYSICS LETTERS, A I P PUBLISHING LLC, US, vol. 76, no. 7, 14 février 2000 (2000-02-14), pages 858-860, XP012025868, ISSN: 0003-6951, DOI: 10.1063/1.125608**

**Description**

DOMAINE TECHNIQUE DE L'INVENTION

La présente invention concerne en général les techniques de croissance de couches de nitrure (N) obtenues à partir d'au moins un matériau pris parmi le gallium (Ga), l'indium (In) et l'aluminium (Al) sur une face d'une couche cristalline.

L'invention trouve notamment pour application avantageuse le domaine des diodes électroluminescentes (DEL) et des lasers.

ÉTAT DE LA TECHNIQUE

Les dispositifs optoélectroniques commerciaux modernes et en particulier les diodes électroluminescentes (DEL) et les lasers utilisent des matériaux semi-conducteurs comprenant un nitrure (N) obtenu à partir d'au moins un matériau pris parmi le gallium (Ga), l'indium (In) et l'aluminium (Al). Ce type de nitrure est classiquement obtenu par croissance épitaxiale à partir d'une couche cristalline.

Un enjeu majeur consiste à minimiser la densité de défauts dans la couche de nitrure obtenue par épitaxie. En effet, les dispositifs électroluminescents de type LEDs et lasers sont très sensibles à la densité de défauts de structure tels que les dislocations. Ces défauts agissent comme des centres de recombinaison non radiatifs qui limitent l'efficacité d'émission. Les performances des dispositifs électroluminescents sont donc fortement dégradées lorsque la densité de défauts dans la couche de nitrure est importante.

Plusieurs raisons expliquent la présence de dislocations.

Une première raison est que la croissance épitaxiale de la couche de nitrure est réalisée sur des hétéro-substrats, c'est-à-dire sur des substrats dont le matériau et donc les paramètres de maille sont différents de ceux de la couche de nitrure que l'on veut épitaxier.

Une deuxième raison qui explique la présence de dislocations est que la croissance épitaxiale s'effectue de manière colonnaire. Ceci est lié principalement à la diffusivité faible des espèces en surface de l'hétéro-substrat pendant la croissance, ce qui se traduit par la formation de grains de taille réduite. Lors de la coalescence, ces grains se joignent en formant à leur interface, c'est-à-dire au niveau du joint de coalescence, des dislocations qui traversent ensuite toute la structure épitaxiée.

La façon la plus directe pour résoudre ces problèmes consiste à utiliser des substrats de même nature que les couches que l'on veut épitaxier (homo-substrats). Par exemple, dans le cas des matériaux nitrures qui couvrent les gammes d'émission allant de l'infrarouge à l'ultraviolet profond, on peut se servir de substrats de GaN pour faire croître par épitaxie des structures émettrices dans le bleu à base de GaN, ou des substrats d'AlN pour les structures émissives dans l'UV profond. L'épitaxie y est alors facile. En effet, la couche épitaxiée reproduit la structure du substrat sous-jacent sans qu'il y ait de grains et donc de joints de coalescence. On évite ainsi la présence de dislocations.

Cependant, ces substrats ne sont pas disponibles commercialement ou ne sont encore que de faibles dimensions, typiquement d'un diamètre inférieur à un pouce (2,5 cm), ce qui ne permet pas d'y découper des substrats de dimensions suffisantes pour les applications industrielles envisagées.

Les solutions envisagées à ce jour pour des applications industrielles reposent donc principalement sur l'utilisation d'hétéro-substrats.

Cependant lorsque l'on utilise des hétérosubstrats, de nombreuses dislocations sont générées dans les couches épitaxiées et ces défauts se propagent jusque dans les zones actives du dispositif. Une solution pour réduire la densité de dislocations consiste à recourir à des méthodes dites de « recroissance latérale » ou ELOG, acronyme de l'anglais « epitaxial lateral overgrowth ».

Le principe de cette méthode repose sur le fait qu'à un certain stade de la croissance épitaxiale, on procède au dépôt d'un masque présentant des ouvertures. Les germes de croissance croissent dans les ouvertures puis au-dessus du masque par recroissance latérale. La recroissance latérale se traduit par la courbure des dislocations issues des germes, ce qui évite donc leur propagation verticale. Ce type de procédé permet donc d'éliminer un grand nombre de dislocations par courbure, mais des dislocations sont aussi créées à la coalescence. En effet lorsque deux cristallites issues de deux ouvertures adjacentes se joignent au-dessus du masque, il se forme un joint de coalescence et la dislocation peut atteindre la surface.

En pratique, si on constate bien que les dislocations sous le masque sont effectivement bloquées, les dislocations qui arrivent à se propager au travers des ouvertures du masque se propagent dans la couche épitaxiée et peuvent atteindre la surface.

Bien sûr, la densité de dislocations traversantes issues de la coalescence est fortement réduite par rapport à ce qu'elle est dans le cas de la coalescence « naturelle », puisque les « grains » sont de dimensions plus importantes (typiquement de l'ordre de la période des ouvertures dans le masque). Mais ces dislocations sont distribuées de façon non uniforme, ce qui peut poser problème lors de la fabrication des dispositifs, puisque résultant de la formation de bandes de matériau non luminescent à l'aplomb de ces zones.

Une autre solution consiste à faire recroître par épitaxie du matériau sur des plots préexistants de ce matériau : il s'agit du procédé dit de pendeo-épitaxie qui permet de s'affranchir de la recroissance sur le masque. En revanche, les solutions connues de pendeo-épitaxie ne permettent pas d'éliminer voire de réduire significativement l'apparition de défauts générés par la coalescence de germes adjacents.

Il existe donc un besoin consistant à proposer une solution pour obtenir une couche de nitrure (N) obtenue à partir d'au moins l'un parmi le gallium (Ga), l'indium (In) et l'aluminium (Al) et présentant une densité de défauts significativement réduite.

Les autres objets, caractéristiques et avantages de la présente invention apparaîtront à l'examen de la description suivante et des dessins d'accompagnement. Il est entendu que d'autres avantages peuvent être incorporés.

RÉSUMÉ DE L'INVENTION

Selon un exemple de réalisation, la présente invention a pour objet un procédé d'obtention d'au moins une couche de nitrure (N) obtenue de préférence à partir d'au moins l'un parmi le gallium (Ga), l'indium (In) et l'aluminium (Al). Le procédé comprend les étapes suivantes:

- fournir un empilement comprenant un substrat et au moins les couches suivantes successivement disposées depuis le substrat :

  - une couche de fluage présentant une température de transition vitreuse $T_{transition}$ vitreuse,
  - une couche cristalline,

- former des plots par gravure au moins de la couche cristalline et d'au moins une portion de la couche de fluage de manière à ce que chaque plot comporte au moins :

  - un tronçon de fluage formé par une portion au moins de la couche de fluage,
  - un tronçon cristallin formé par la couche cristalline et surmontant le tronçon de fluage ;

- faire croitre par épitaxie une cristallite sur certains au moins desdits plots et poursuivre la croissance épitaxiale des cristallites au moins jusqu'à coalescence des cristallites portées par deux plots adjacents, de manière à former ladite couche de nitrure, la croissance épitaxiale étant effectuée à une température $T_{épitaxie}$, telle que :

$$T_{épitaxie} \geq k1 . T_{transition\ vitreuse}, \text{ avec } k1 = 0.8$$

Ainsi, lors de l'épitaxie, la portion du plot qui est formée par le tronçon de fluage atteint (ou dépasse) sa température de transition vitreuse ou une température très proche de cette dernière. Sous l'effort d'une contrainte mécanique, cette portion de plot peut ainsi se déformer. Ainsi lorsque deux cristallites entrent en contact et coalescent, les contraintes mécaniques générées par ce contact sont transférées aux plots et donc aux tronçons de fluage. Ce dernier se déforme, absorbant de ce fait une partie voire toutes les contraintes mécaniques. On peut ainsi réduire considérablement, voire éviter, l'apparition et la propagation de dislocations au niveau des joints de coalescence entre deux cristallites.

En particulier, si les cristallites sont désorientés les uns par rapport aux autres dans le plan dans lequel le substrat s'étend principalement (« twist ») ou hors plan (« tilt »), la désorientation entre cristallites résulte en la création d'un joint de grains à la coalescence. Ce joint de grains est fortement énergétique puisqu'il résulte de la superposition des champs de contrainte des défauts qui le composent. Si les cristallites poussent sur des plots qui peuvent se déformer, les cristallites adjacentes s'orientent dans le plan ou hors plan pour minimiser l'énergie élastique totale du système sans qu'il y ait formation de joints de grains.

L'invention permet ainsi d'obtenir des couches de nitrure (N) obtenue à partir d'au moins l'un parmi le gallium (Ga), l'indium (In) et l'aluminium (Al) présentant une densité de dislocations significativement réduite.

Par conséquent, le procédé selon l'invention apporte une solution particulièrement efficace au problème de la génération de défauts liés à la coalescence. Ce procédé, tout particulièrement lorsqu'il est appliqué à des cristallites réalisées sur substrat du type SOI (silicium sur isolant) et de dimensions nanométriques, résulte en une réduction très notable de la densité de défauts liés à la coalescence, permettant la réalisation de pseudo-substrats avec de très faibles densités de dislocations.

L'invention a également pour avantage de faciliter l'obtention de LEDs émettant dans la longueur d'onde du rouge. En effet, l'invention permet d'obtenir des couches de l'alliage GaInN présentant peu voire pas de défauts et contraintes, ce qui permettra d'incorporer plus d'indium et donc d'obtenir plus facilement des LEds rouges.

Avant d'entamer une revue détaillée de modes de réalisation de l'invention, sont énoncées ci-après des caractéristiques optionnelles qui peuvent éventuellement être utilisées en association ou alternativement.

Selon un exemple de réalisation, en début de croissance épitaxiale, chaque cristallite est entièrement supportée par uniquement un plot. De préférence, lors de l'étape de croissance épitaxiale, une cristallite se développe sur chacun des plots.

Selon un exemple de réalisation, la couche de fluage est faite d'un matériau visqueux. Il présente une transition visco-plastique. De préférence ce matériau est pris parmi :

- un oxyde de silicium SixOy, x et y étant des entiers. De préférence, la couche de fluage est en SiO2,
- un verre,
- un verre en borosilicate,
- un verre en borophosphosilicate (BPSG)

Selon un exemple de réalisation, k1 = 0.87 ou k1 = 0.9.

Selon un exemple particulièrement avantageux, k1= 0.92. Ainsi, dans le cas où les tronçons de fluage sont formés en SiO2, $T_{éptaxie} \geq 1104°C$, $T_{transition}$ vitreuse pour le SiO2 étant égale à 1200°C.

Selon un exemple de réalisation encore plus préférentiel, k1 = 0.95. Selon un exemple de réalisation encore plus préférentiel, k1 = 1, et de préférence k1 = 1,5.

Selon un exemple de réalisation, $T_{épitaxie} \leq k2 \cdot T_{fusion\ min}$, $T_{fusion\ min}$ étant la température de fusion la plus faible parmi les températures de fusion des matériaux formant les tronçons du plot. Il s'agit principalement du tronçon cristallin et du tronçon de fluage.

Selon un exemple de réalisation, k2 = 0.9. Cela permet d'éviter une diffusion des espèces du matériau dont la température de fusion est la plus faible.

Ainsi, dans le cas où le plot est formé de tronçons de fluage en SiO2 et de tronçons cristallins en silicium, $T_{épitaxie} \leq 1296°C$. En effet, $T_{fusion\ min}$ est égale à la température de fusion du silicium puisque la température de fusion du silicium est égale à 1440° et la température de fusion du SiO2 est égale à 1970°C.

De préférence, k2= 0.8.

Selon un exemple de réalisation, les plots comprennent au moins une couche tampon, en un matériau différent de celui de ladite couche de nitrure, surmontant la couche cristalline, et de préférence ladite couche de nitrure est une couche de nitrure de gallium (GaN) et la couche tampon est en nitrure d'aluminium (AIN).

Cela permet, lorsque ladite couche de nitrure est une couche de nitrure de gallium (GaN), d'éviter l'apparition du phénomène de melt back etching (gravure par refusion), généré par la très forte réactivité entre le gallium et le silicium.

Selon un exemple de réalisation, la couche tampon est formée par dépôt par épitaxie au-dessus de la couche cristalline, avant l'étape de formation de la pluralité de plots par gravure.

Selon un exemple de réalisation l'empilement comprend, avant l'étape de croissance épitaxiale de ladite couche de nitrure, au moins ladite couche tampon.

Le fait de former la pluralité de plots par gravure après la formation de la couche tampon au-dessus de la couche cristalline, permet d'éviter que la couche tampon ne se dépose entre les plots, typiquement sur le fond de la couche de fluage ou ne se dépose sur les parois des tronçons formés par la couche cristalline, ce qui aurait été le cas si cette étape de formation de la couche tampon avait été réalisée après gravure de l'empilement pour former les plots. On évite ainsi la croissance épitaxiale de la couche de nitrure à partir de la couche de fluage. Naturellement, on observe cet avantage lorsque la croissance de la couche de nitrure déposée par épitaxie s'effectue de manière sélective. Cette croissance s'effectue en effet sur le matériau de la couche tampon mais ne s'effectue pas sur le matériau des tronçons de fluage. Tel est le cas lorsque ces derniers sont en SiO2, la couche tampon est en AIN et la couche de nitrure déposée par épitaxie, par exemple selon une technique MOVPE (épitaxie en phase vapeur aux organométalliques), est du GaN. Ainsi ce dernier ne se dépose pas au pied des plots.

Selon un exemple de réalisation avec ou sans couche-tampon, ladite couche de nitrure est une couche de nitrure de gallium (GaN) et les plots comprennent, avant l'étape de croissance épitaxiale de ladite couche de nitrure, au moins une couche d'amorçage, surmontant ladite couche tampon et faite de nitrure de gallium (GaN).

Selon un exemple de réalisation, l'empilement comprend, avant ladite étape de formation des plots par gravure, au moins une couche d'amorçage, surmontant ladite couche cristalline, la couche d'amorçage étant faite du même matériau que ladite couche de nitrure.

Ainsi, dans un mode de réalisation dans lequel ladite couche de nitrure est du GaN, la couche d'amorçage est également en GaN.

Avantageusement, cette couche d'amorçage permet de faciliter la reprise de la croissance épitaxiale pour la formation des cristallites. Cette caractéristique est d'autant plus avantageuse que la surface du sommet des plots est faible.

Ainsi, si le sommet du plot, c'est-à-dire la face supérieure du plot, découverte, est formé par le tronçon cristallin, alors on fait croître par épitaxie les cristallites directement au contact de la couche cristalline.

Ainsi, si le sommet du plot est formé par la couche d'amorçage, alors on fait croître par épitaxie les cristallites directement au contact de la couche d'amorçage.

Ainsi, si le sommet du plot est formé par la couche tampon, alors on fait croître par épitaxie les cristallites directement au contact de la couche tampon.

De préférence, la couche d'amorçage est disposée directement au contact de la face supérieure du tronçon cristallin.

Chaque plot présente une face supérieure et dans lequel la croissance par épitaxie des cristallites s'effectue en partie au moins et de préférence uniquement à partir de ladite face supérieure.

De préférence, la couche tampon est disposée directement au contact de la face supérieure du tronçon cristallin ou au contact de la face supérieure du tronçon formé par la couche amorçage.

Selon un exemple, au moins l'une parmi la couche tampon et la couche d'amorçage conserve une épaisseur constante au cours de l'étape de croissance par épitaxie.

Selon un exemple de réalisation, fournir ledit empilement revient à fournir un substrat élaboré de type silicium sur isolant (SOI) comprenant un substrat de base surmonté successivement d'une couche d'oxyde formant ladite couche de fluage et d'une couche semiconductrice formant ladite couche cristalline.

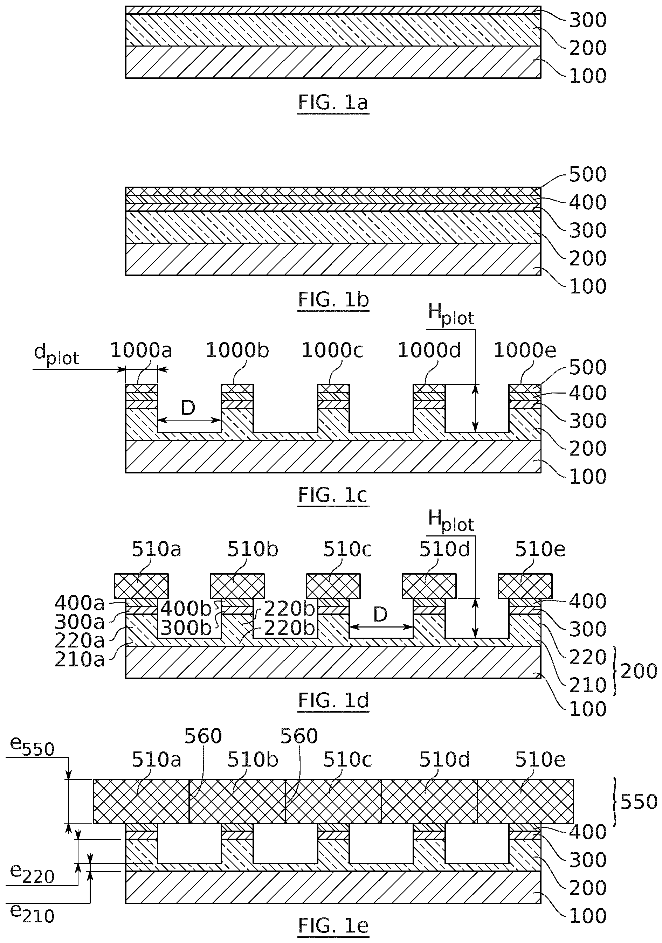

Selon un exemple de réalisation, la hauteur $e_{220}$ que le tronçon de fluage doit présenter est telle que $e220 \geq 0.017 * d_{plot}$, $d_{plot}$ étant le diamètre du plot ou plus généralement la distance bord à bord du plot prise, au niveau du tronçon de fluage et dans une direction parallèle au plan principal dans lequel s'étend le substrat, par exemple selon l'horizontale sur les figures 1c à 1e

De préférence, $e220 \geq 0.05 * d_{plot}$. De préférence, $e220 \geq 0.1 * d_{plot}$. De préférence, $e220 \geq 1 * d_{plot}$.

Ces valeurs, permettent d'obtenir une déformation suffisante pour réduire les contraintes au niveau du joint de grain.

Selon un exemple, $d_{cristallite} / d_{plot} \geq k3$, $d_{plot}$ étant le diamètre du plot ou plus généralement la distance bord à bord du plot prise, c'est-à-dire la dimension maximale du plot quelle que soit la forme de sa section, au niveau du tronçon de fluage et dans une direction parallèle au plan principal dans lequel s'étend le substrat, par exemple selon l'horizontale sur les figures 1c à 1e. $d_{cristallite}$ correspond à la dimension de la cristallite mesurée selon la même direction que $d_{plot}$. On notera que $d_{cristallite}$ correspond au pas entre deux plots. Ainsi, comme illustré sur la figure 1c à 1e, au moment de la coalescence $d_{cristallite} = D + d_{plot}$.

Des résultats particulièrement efficaces ont été obtenus pour $k3 = 3$. Selon un exemple $100 \geq k3 \geq 3$. De préférence, $50 \geq k3 \geq 3$. De préférence, $5 \geq k3 \geq 3$.

Cette caractéristique permet aux tronçons de fluage de se déformer pour encaisser de manière particulièrement efficace les contraintes mécaniques qui naissent lorsque deux cristallites adjacentes commencent à coalescer. Ainsi, cette caractéristique contribue efficacement à réduire la densité de défauts au sein de la couche de nitrure que l'on obtient au final.

Selon un exemple de réalisation, les tronçons présentent une hauteur $e220$ et deux plots adjacents sont distants d'une distance D, telle que :

$$e220 / D < 1 \text{ , et de préférence } e220 / D < 1.5. \text{ De préférence } e220 / D < 2.$$

Selon un exemple de réalisation, les plots présentent une hauteur $H_{plot}$ et deux plots adjacents sont distants d'une distance D, telle que :

$$H_{plot} / D < 2 \text{ , et de préférence } H_{plot} / D < 1.5. \text{ De préférence } H_{plot} / D < 1.$$

La distance D et la hauteur $H_{plot}$ sont référencées en figure 1d. Selon un exemple de réalisation, la hauteur $H_{plot}$ correspond uniquement à l'épaisseur du tronçon de fluage et à l'épaisseur du tronçon cristallin.

Selon un exemple de réalisation, la couche cristalline est à base de silicium. De préférence la couche cristalline est en silicium. La couche cristalline peut être aussi à base de matériaux autres que Si et qui permettent l'épitaxie de matériaux nitrures. Par exemple, la couche cristalline peut être à base de SiC ou de $Al_2O_3$. Ces matériaux sont en outre utilisables sous la forme de SiCOI (SiC on Insulator, c'est-à-dire de SiC sur isolant) ou de SOS (silicium sur saphir).

Selon un exemple de réalisation la couche cristalline est une couche mono-cristalline.

Selon un exemple de réalisation, la couche de fluage est au contact direct avec le substrat. La couche de fluage est au contact direct de la couche cristalline. Selon un exemple de réalisation, la couche de nitrure que l'on réalise par coalescence de cristallites est au contact direct de la couche cristalline. Selon un autre mode de réalisation, on prévoit au moins une couche intermédiaire entre la couche cristalline et la couche de nitrure que l'on réalise par coalescence de cristallites. Cette couche intermédiaire forme typiquement la couche tampon.

Ainsi, la couche de fluage et la couche cristalline sont différentes. La couche de fluage présente une température de transition vitreuse. Elle est donc faite d'un matériau à transition vitreuse et présente le comportement des matériaux à transition vitreuse. Ainsi, la couche de fluage n'est pas cristalline. Elle est faite d'un matériau visqueux ou vitreux, par exemple d'un oxyde. La couche de fluage et la couche cristalline ne sont pas faites du même matériau.

Selon un exemple de réalisation, la couche de fluage présente une épaisseur $e_{220}$ inférieure à 500nm ($10^{-9}$ mètres). Elle est de préférence comprise entre 50 nm et 500 nm et de préférence entre 100 nm et 150 nm.

Selon un exemple de réalisation, la couche cristalline présente une épaisseur comprise entre 2 nm ($10^{-9}$ mètres) et 10 $\mu$m ($10^{-6}$ mètres) et de préférence entre 5nm et 500 nm et de préférence entre 10 nm et 50nm.

Selon un exemple de réalisation, on fait croitre par épitaxie une cristallite sur tous lesdits plots.

Selon un exemple de réalisation, le rapport V/III des flux dans le réacteur de dépôt par épitaxie (les flux étant par exemple mesurés en sccm) dudit matériau comprenant du nitrure (N) et au moins l'un parmi le gallium (Ga), l'Indium (In) et l'aluminium (Al) est compris entre 100 et 2000.

Selon un exemple de réalisation, le rapport V/III des flux du matériau formant ladite couche de nitrure (N) et au moins l'un parmi le gallium (Ga), l'Indium (In) et l'aluminium (Al) est compris entre 300 et 500 et de préférence entre 380 et 420.

Selon un exemple de réalisation, la couche de nitrure est en nitrure de gallium (GaN). Selon un autre mode de réalisation, la couche de nitrure est à base de nitrure de gallium (GaN) et comprend en outre de l'aluminium (Al) et/ou de l'indium (In).

Selon un autre mode de réalisation, le matériau formant ladite couche de nitrure (N) est l'un quelconque parmi : le nitrure de gallium (GaN), le nitrure d'indium (InN), le nitrure d'aluminium (AlN), le nitrure d'aluminium gallium (AlGaN), le nitrure d'indium gallium (InGaN), le nitrure d'aluminium gallium indium (AlGaInN), le nitrure d'aluminium indium (AlInN), le nitrure d'aluminium indium Gallium (AlInGaN).

Selon un autre mode de réalisation, la présente invention a pour objet un dispositif microélectronique comprenant un substrat surmonté d'une pluralité de plots, chaque plot comprenant au moins :

- un tronçon de fluage, présentant une température de transition vitreuse $T_{transition}$ vitreuse,

- un tronçon formé d'un matériau cristallin.

Le dispositif comprend également une couche de nitrure (N) obtenue à partir d'au moins l'un parmi le gallium (Ga), l'indium (In) et l'aluminium (Al), ladite couche étant entièrement supportée par les plots.

Le matériau du tronçon de fluage et le matériau de ladite couche de nitrure sont choisis de manière à ce que:

$$T_{épitaxie} \geq k1.\ T_{transition\ vitreuse},\ \text{avec } k1=0.8,$$

$T_{épitaxie}$ étant la température minimale permettant la formation par épitaxie de la couche de nitrure.

Selon un exemple particulièrement avantageux, k1= 0.92. Selon un exemple de réalisation encore plus préférentiel, k1 = 0.95. Selon un exemple de réalisation encore plus préférentiel, k1 = 1, et de préférence k1 = 1,5.

Selon un exemple particulièrement avantageux, l'étape de croissance par épitaxie de la couche de nitrure comprend :

- une première étape utilisant des premières conditions de croissance choisies de sorte à réaliser par épitaxie des pyramides sur chacun des plots et jusqu'à ce que les pyramides se jouxtent ;

- une deuxième étape, utilisant des deuxièmes conditions de croissance choisies de sorte à induire une croissance latérale afin d'assurer la coalescence des pyramides.

Les conditions de croissance comprennent des paramètres notamment relatifs à la pression, la température et le rapport des espèces chimiques utilisées pour la croissance.

Selon un exemple, la couche cristalline n'est pas contrainte. Son paramètre de maille étant égal à son paramètre de maille nominal, c'est-à-dire à son paramètre de maille à l'état naturel.

Selon un autre mode de réalisation, la présente invention a pour objet une diode électroluminescente (LED) comprenant au moins un dispositif microélectronique selon l'invention.

Par dispositif microélectronique, on entend tout type de dispositif réalisé avec des moyens de la microélectronique. Ces dispositifs englobent notamment en plus des dispositifs à finalité purement électronique, des dispositifs micromécaniques ou électromécaniques (MEMS, NEMS...) ainsi que des dispositifs optiques ou optoélectroniques (MOEMS...)

BRÈVE DESCRIPTION DES FIGURES

Les buts, objets, ainsi que les caractéristiques et avantages de l'invention ressortiront mieux de la description détaillée de modes de réalisation de cette dernière qui est illustré par les dessins d'accompagnement suivants dans lesquels :

La FIGURE 1, composée des FIGURES 1a à 1e, illustre des étapes d'un exemple de procédé selon la présente invention.
La FIGURE 2a illustre de manière schématique, en vue du dessus, la coalescence de deux cristallites dans le cadre d'un procédé classique de pendeo-épitaxie.
La FIGURE 2b illustre de manière schématique, en vue du dessus, la coalescence de deux cristallites dans le cadre d'un exemple de procédé selon la présente invention.
La FIGURE 3, composée des FIGURES 3a et 3b illustrent de manière schématique, en vue de côté, la coalescence de deux cristallites dans le cadre d'un exemple de procédé selon la présente invention.
La FIGURE 4 est une photo illustrant un plot surmonté d'une cristallite, obtenue par mise en œuvre d'un exemple de procédé selon la présente invention.
La FIGURE 5 est composée des figures 5a et 5b qui sont des photos montrant une couche obtenue par épitaxie après mise en œuvre du procédé selon la présente invention.
La FIGURE 6 est composée des figures 6a à 6c qui sont des photos illustrant le résultat de la mise en œuvre d'un exemple de procédé selon la présente invention.
La FIGURE 7 est composée des figures 7a à 7c qui sont des photos illustrant le résultat de la mise en œuvre d'un exemple de procédé selon la présente invention.
La FIGURE 8 est composée des figures 8a à 8b qui sont des photos illustrant respectivement, en vue de côté en coupe et en vue du dessus, le résultat de la mise en œuvre d'un exemple de procédé selon la présente invention.

Les figures sont données à titre d'exemples et ne sont pas limitatives de l'invention. Elles sont des représentations schématiques de principe destinées à faciliter la compréhension de l'invention et ne sont donc pas nécessairement à la même échelle que les applications pratiques. En particulier, les épaisseurs relatives des différentes couches, tronçons et cristallites ne sont pas représentatives de la réalité.

DESCRIPTION DÉTAILLÉE DE L'INVENTION

Il est précisé que dans le cadre de la présente invention, les termes « sur », « surmonte », « recouvre » ou « sous-jacent » ou leurs équivalents ne signifient pas « au contact de ». Ainsi par exemple, « le dépôt d'une première couche sur une deuxième couche » ne signifie pas obligatoirement que les deux couches sont directement au contact l'une de l'autre mais cela signifie que la première couche recouvre au moins partiellement la deuxième couche en étant soit directement à son contact soit en étant séparée d'elle par au moins une autre couche ou au moins un autre élément y compris de l'air.

Dans la description qui suit, l'épaisseur ou la hauteur est prise selon une direction perpendiculaire aux faces principales des différentes couches. Sur les figures, l'épaisseur ou la hauteur est prise selon la verticale.

De même lorsqu'on indique qu'un élément est situé au droit d'un autre élément, cela signifie que ces deux éléments sont situés tous deux sur une même ligne perpendiculaire au plan principal du substrat, soit sur une même ligne orientée verticalement sur les figures.

On entend par une couche, « à base » d'un matériau A, une couche comprenant ce matériau A uniquement ou comprenant ce matériau A et éventuellement d'autres matériaux, par exemple des éléments dopants

Dans la suite de la description, les termes cristaux et cristallites seront considérés comme équivalents.

Le principe général du procédé selon l'invention va maintenant être décrit en référence aux **figures 1a** à 1e.

Comme illustré en **figure 1a,** on fournit un empilement comprenant au moins un substrat 100, surmonté successivement d'une couche de fluage 200 et d'une couche cristalline de 300. Ainsi la couche de fluage 200 est disposée entre le substrat 100 et la couche cristalline de 300.

Selon un exemple de réalisation le substrat 100 est à base de silicium, amorphe ou cristallin. Il assure la tenue mécanique de l'empilement.

La couche cristalline 300 présente une face inférieure en regard de la couche de fluage 200 et une face supérieure dont la fonction est de servir de couche de base pour faire croître par épitaxie la couche de nitrure que l'on souhaite obtenir au final. Par exemple, la couche que l'on souhaite obtenir au final est une couche 550 de nitrure de gallium GaN. Selon un exemple de réalisation, la couche cristalline 300 est à base de silicium monocristallin.

De préférence, la couche de fluage 200 est faite d'un matériau visqueux. Elle est faite d'un matériau amorphe tel qu'un oxyde, de préférence un oxyde de silicium SixOy, tel que le SiO2. Le rôle de cette couche sera explicité dans la suite de la description.

La couche de fluage 200, présente une température de transition vitreuse. Elle présente donc une transition vitreuse et présente le comportement des matériaux à transition vitreuse. Comme tous les matériaux présentant une température de transition vitreuse, la couche de fluage 200 sous l'effet d'une élévation de température, se déforme sans rompre et sans reprendre sa position initiale après une baisse de température. Au contraire, la couche cristalline 300 ne présente naturellement pas de transition vitreuse. Lorsqu'un seuil de température est atteint, la couche cristalline se déforme, puis se disloque et peut rompre.

De manière avantageuse mais non limitative, cet empilement constitue un substrat de type semi-conducteur sur isolant, de préférence silicium sur isolant (SOI). Dans ce cas, la couche de fluage 200 est formée par la couche d'oxyde enterré (BOX) du substrat SOI.

Selon un exemple de réalisation avantageux illustré en **figure 1b,** on dépose, par épitaxie sur la face supérieure de la couche cristalline 300, une couche tampon 400. Lorsque la couche 550 que l'on souhaite obtenir au final est une couche de GaN et que la couche cristalline 300 est une couche à base de silicium, cette couche tampon 400 est typiquement en nitrure d'aluminium (AIN). Cela permet d'éviter le phénomène dit de «Melt-back etching» (gravure par refusion), généré par la très forte réactivité entre le silicium et le gallium aux températures usuelles d'épitaxie (1000/1100°C) et qui conduit à dégrader très fortement la couche de GaN.

Typiquement, l'épaisseur de la couche d'AIN est comprise entre 50 et 200 nanomètres ($10^{-9}$ mètres).

Par conséquent, la couche de fluage 200 et la couche cristalline 300 sont différentes. La couche de fluage 200 n'est pas cristalline.

Comme illustré en **figure 1b,** on peut également déposer par épitaxie, sur la face supérieure de la couche tampon 400, une couche d'amorçage 500. Cette couche d'amorçage 500 a pour fonction de faciliter la reprise de croissance des cristallites 510 lors des étapes suivantes. Dans ce cas, c'est à partir d'une face supérieure de la couche d'amorçage 500 que se produit en partie au moins la croissance par épitaxie de la cristallite (510a-510e). Cette couche d'amorçage 500 est de préférence réalisée dans le même matériau que la couche 550 que l'on souhaite obtenir au final. Typiquement, lorsque la couche que l'on souhaite obtenir au final est une couche 550 de nitrure de gallium GaN, la couche d'amorçage 500 est également en GaN. Elle présente typiquement une épaisseur comprise entre 50 et 200 nanomètres.

On notera que les couches 400 et 500 sont uniquement optionnelles.

Selon des modes de réalisation non illustrés en figure 1, on pourra prévoir uniquement la couche tampon 400 ou uniquement la couche d'amorçage 500, ou encore aucune de ces deux couches 400 et 500.

Quel que soit le mode de réalisation retenu, c'est-à-dire avec ou sans couche d'amorçage 400 et avec ou sans couche tampon 500, la croissance par épitaxie de la cristallite 510a-510e, s'effectue en partie au moins ou uniquement à partir de la face supérieure du plot 1000a-1000e. Ainsi, cette face supérieure est formée soit par le tronçon cristallin 300a-300b, soit par le tronçon formé par la couche d'amorçage 400a-400b, soit par le tronçon formé par la couche tampon. Cela permet notamment d'obtenir rapidement des cristallites d'épaisseur importante.

On remarquera que les faces supérieures de la couche tampon 400 et de la couche d'amorçage 500, c'est-à-dire les faces tournées au regard de la couche de nitrure 550 que l'on souhaite faire croître, présentent des polarités de type Gallium (Ga), et non pas azote (N), ce qui facilite considérablement l'obtention d'une couche de nitrure 550 épitaxiée de grande qualité.

Comme illustré en **figure 1c,** on forme des plots 1000a-1000e à partir de l'empilement. Ces plots sont obtenus par gravure de l'empilement jusque dans la couche de fluage 200.

Pour former les plots par gravure, on pourra recourir aux nombreuses techniques de gravure connues de l'homme du métier. On pourra notamment utiliser les techniques classiques de lithographie, telles que les techniques de photolithographie comprenant la formation d'un masque, par exemple en résine, puis le transfert des motifs du masque dans l'empilement. On pourra également recourir aux techniques de lithographie par faisceau d'électrons (e-beam) ou aux techniques d'impression nanométrique.

Ces plots 1000a-1000e sont de faibles dimensions et peuvent être qualifiés de nano-plots. Typiquement, la dimension maximale de la section des plots est comprise entre quelques dizaines et quelques centaines de nanomètres, plus précisément entre 10 et 500 nanomètres et de préférence 100 nm. Cette dimension maximale de la section des plots est référencée $d_{plot}$ en figure 1c. Si les plots sont de sections circulaires, cette dimension maximale $d_{plot}$ correspond au diamètre des plots. Si les plots sont de section hexagonale, cette dimension maximale $d_{plot}$ correspond à la diagonale ou au diamètre du cercle passant par les angles de l'hexagone.

Selon un exemple de réalisation, les tronçons présentent une hauteur e220 et deux plots adjacents sont distants d'une distance D, telle que :

e220 / D <1 , et de préférence e220 / D <1.5. De préférence e220 / D <2.

Selon un exemple de réalisation, les plots présentent une hauteur $H_{plot}$ et deux plots adjacents sont distants d'une distance D, telle que :

$$H_{plot} / D <2 , \text{ et de préférence } H_{plot} / D <1.5. \text{ De préférence } H_{plot} / D ≤ 1.$$

La distance D est la hauteur $H_{plot}$ sont référencées en figure 1d.

Comme illustré en **figure 1c,** les plots sont gravés à travers toute la couche d'amorçage 500, toute la couche tampon 400 (lorsque ces dernières sont présentes), toute la couche cristalline 300. De préférence, seule une portion 220 de la couche de fluage 200 est gravée. Ce mode de réalisation présente pour avantage d'éviter que lors de l'épitaxie la couche de nitrure 550 se développe sur les tronçons de fluage 220. Cette sélectivité de l'épitaxie se rencontre notamment lorsque la couche nitrure 550 que l'on fait croître par épitaxie est du GaN et que les tronçons de fluage sont en SiO2. Au contraire, si, avec ces mêmes matériaux, la couche de fluage 200 est gravée sur toute son épaisseur, alors lors de épitaxie, la couche nitrure se développe à partir de la face supérieure du substrat 100, habituellement formée de silicium. Cette situation n'est évidemment pas souhaitable

Par ailleurs, il a été observé que le fait de conserver une portion 210 non gravée de la couche de fluage 200 permet de faciliter le fluage du tronçon 220, en particulier lorsque les cristallites sont désorientés en twist, c'est-à-dire dans le plan de la couche nitrure 550 que l'on souhaite obtenir.

De manière préférée, l'épaisseur e220 gravée, et formant donc la hauteur du tronçon de fluage 220, est égale à la moitié de l'épaisseur de la couche fluage 200. Cela permet d'avoir une très bonne réorientation des cristallites lors de la formation de joints de grains.

La **figure 1d** illustre la formation de cristallites 510a-510e par croissance épitaxiale à partir de la couche d'amorçage 500 (ou de la face supérieure de la couche cristalline 300 lorsque les couches 400 et 500 sont absentes).

Comme illustré sur cette figure1d, les plots 1000a-1000e comprennent chacun une cristallite 510a-510e portée par un empilement de tronçons 400a-400e, 300a-300e, 220a-220e. Les tronçons s'étendent selon la direction principale d'extension du plot, c'est-à-dire verticalement sur les figures 1a à 1e.

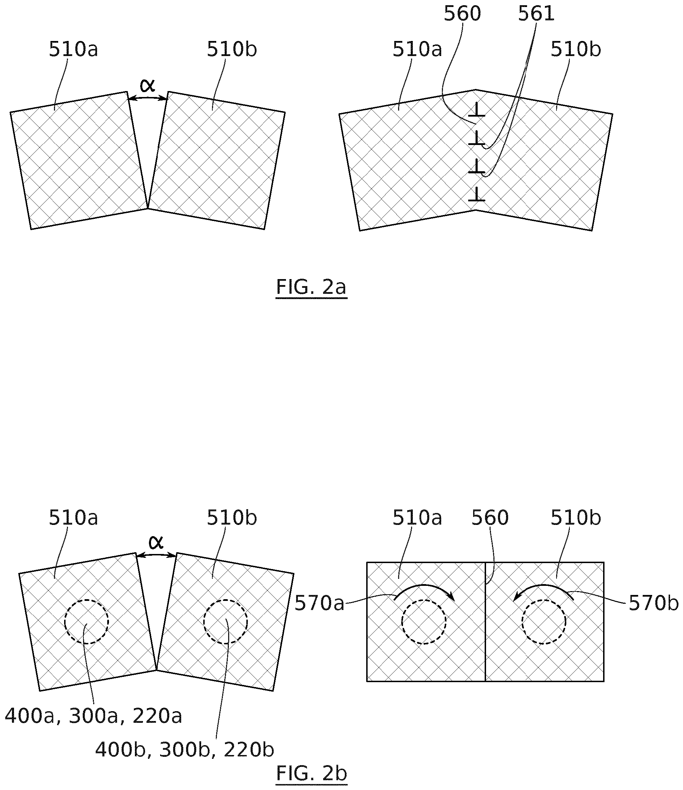

Les tronçons forment des disques si la section des plots est principalement circulaire. Si la section des plots 1000a-1000e est polygonale, par exemple hexagonale, les tronçons forment alors des cylindres de section hexagonale. De préférence, les tronçons sont pleins. Autrement dit et comme clairement illustré sur les figures, la section des plots est prise selon un plan parallèle aux plans dans lesquels la couche fluage 220 et la couche cristalline 300 s'étendent principalement. Ainsi, cette section est prise selon un plan perpendiculaire au plan de la feuille comprenant les figures 1a à 1e et selon un plan parallèle au plan de la feuille comprenant les figures 2a et 2b.

La croissance se poursuit et s'étend latéralement. Les cristallites 510a-510e se développent jusqu'à coalescer et former une couche 550 comme illustré en figure 1e.

Autrement dit, et comme cela ressort clairement des figures, la couche 550 s'étend entre plusieurs plots. Elle est continue.

Cette croissance des cristallites 510a-510e ne s'étend pas vers le bas. Par ailleurs, cette croissance est sélective en ce qu'elle n'a pas lieu sur la couche de fluage 200 typiquement faite d'un oxyde. En ce sens, la croissance des cristallites 510a-510e s'effectue selon le principe de pendeo-épitaxie.

On notera qu'il est particulièrement avantageux de graver les plots 1000a-1000e après formation par épitaxie de la couche tampon 400 et de la couche d'amorçage 500 (lorsque ces couches sont présentes). En effet, si l'une de ces couches 400, 500 était déposée après gravure, elle se formerait en partie au moins entre les plots 1000a-1000e sur la face supérieure de la couche de fluage 200. Dans le cas où la couche nitrure 550 est du GaN, que la couche de fluage 200 est du SiO2, alors, à la température du dépôt par épitaxie, la croissance épitaxiale de la couche 550 ne s'effectuerait pas de manière sélective mais aurait au contraire également lieu entre les plots 1000a-1000e, ce qui naturellement n'est pas souhaitable.

De manière particulièrement avantageuse, la température $T_{épitaxie}$ à laquelle on effectue l'épitaxie est supérieure ou de l'ordre de la température $T_{transition}$ vitreuse de transition vitreuse de la couche de fluage 200. Ainsi, lors de l'épitaxie, les tronçons de fluage 220a-220e sont portés à une température qui leur permet de se déformer

Par conséquent, si les cristallites 510a-510b portées par deux plots 1000a-1000b adjacents sont désorientées l'une par rapport à l'autre, lors de la coalescence de ces deux cristallites, le joint 560 formé à leur interface, habituellement désigné joint de grains ou joint de coalescence, se formera sans dislocation pour rattraper ces désorientations. La déformation des tronçons de fluage 220a-220e permet ainsi de rattraper ces désorientations.

Comme illustré en **figures 2a et 2b,** la désorientation des deux cristallites 510a-510b peut résulter d'un défaut d'alignement dans le plan (c'est-à-dire autour d'axes contenus dans le plan des figures 1a-1e), on parle alors de twist.

La figure 2a, qui présente une vue du dessus des cristallites 510a-510b, illustre ce type de défaut d'alignement avec la présence d'un angle $\alpha$ entre les cristallites. Cette figure 2a illustre de manière schématique que, avec les procédés classiques, le joint 560 qui se forme lors de la coalescence donne naissance à des dislocations 561 pour rattraper les défauts d'alignement.

La figure 2b illustre de manière très schématique la formation du joint de coalescence 560 en mettant en œuvre le procédé selon l'invention. Cette figure 2b fait apparaître la déformation en torsion 570a, 570b des tronçons de fluage 220a, 220b permettant de former un joint de coalescence 560 sans dislocation. Dans ce cas, le rattrapage de cette déformation par les tronçons de fluage 220a-220b conduit à une torsion des tronçons de fluage 220a-220b autour de leur axe principal. Chaque tronçon tourne dans un sens opposé comme illustré sur la vue de droite de la figure 2b.

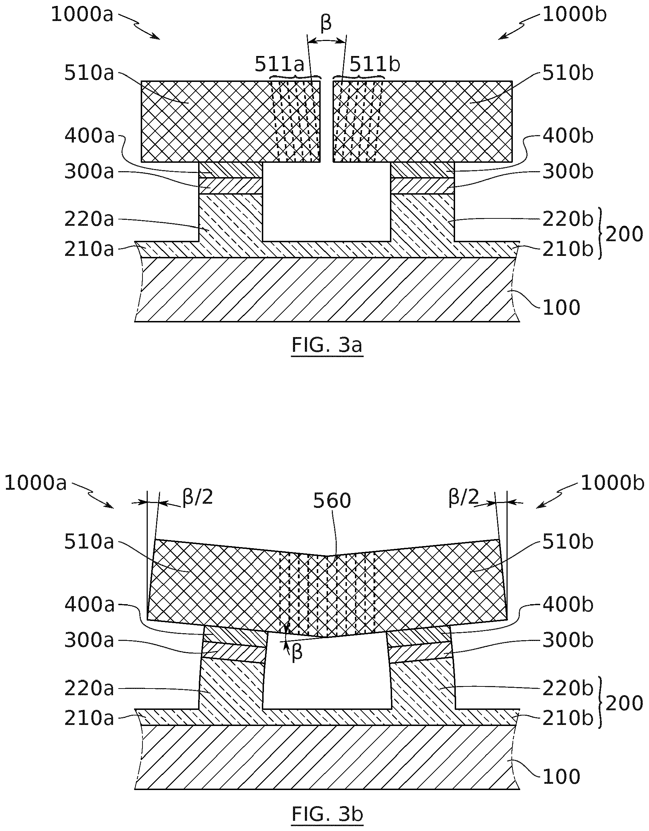

Comme illustré en **figures 3a et 3b,** le défaut d'orientation des deux cristallites peut également résulter d'un défaut d'alignement hors du plan (c'est-à-dire autour d'axes perpendiculaires au plan des figures 1a-1e), on parle alors de tilt. Dans ce cas, le rattrapage de cette déformation par les tronçons de fluage 220a-220e conduit à une inclinaison des plots.

La figure 3a illustre par l'angle $\beta$ le défaut d'orientation angulaire entre les plans cristallins des cristallites 510a et 510b avant coalescence. La figure 3b illustre de manière très schématique la déformation du tronçon de fluage 220 permettant de former un joint de coalescence 560 sans dislocation. On a supposé dans ce schéma que la désorientation est répartie de façon égale entre les deux cristallites 510a et 510b, soit de $\beta/2$. Le schéma est aussi applicable dans le cas où les désorientations cristallines sont différentes en angle dans les deux cristallites adjacentes et dont la somme est égale à $\beta$.

Les figures 2 et 3 n'ont pas pour objectif de donner une représentation visuelle proche de la réalité concernant la déformation des tronçons du fluage. Ces figures visent à donner une représentation schématique pour comprendre facilement le principe de fonctionnement de l'invention.

Les paragraphes qui suivent visent à donner des explications et précisions additionnelles concernant le principe de fonctionnement de l'invention.

## Modélisation et explication du principe de l'invention

Les paragraphes ci-dessous visent à expliquer de manière plus précise les phénomènes à l'origine de l'invention et qui permettent d'obtenir une couche épitaxiée sans ou avec très peu de dislocation.

Lorsque deux grains ou cristallites sont rigidement liés au substrat sur lesquels ils ont été déposés et sont légèrement désorientés l'un par rapport à l'autre, l'énergie de formation de leur joint de coalescence est élevée (on peut assez aisément en calculer l'énergie puisqu'il s'agit en première approximation d'un réseau de dislocations interfaciales. On pourra pour cela se référer à la publication suivante : J.P.Hirth et J. Lothe "Theory of dislocations", John Wiley and sons (1982).

En revanche, si les cristallites 510 reposent sur des plots 1000a-1000e comme c'est le cas en pendeo-épitaxie, et que ces plots 1000a-1000e peuvent se déformer, par torsion (twist) ou inclinaison (tilt), la désorientation des cristallites 510 (par exemple de GaN) les unes par rapport aux autres est « transmise » aux plots portant ces cristallites 510. Dans le cas d'une simple torsion (twist), comme illustré en figure 2b, on peut modéliser le phénomène en disant que les forces attractives qui amènent les cristallites à effectuer une rotation pour se joindre et former une surface « interne » résultent en un couple de torsion au niveau des nano plots 1000a-1000e. Ce couple de torsion sera d'autant plus important que le rapport entre taille de plots 1000a-1000e et taille des cristallites est petit. Si la déformation des plots 1000a-1000e est facile, le joint de coalescence 560 se transforme alors simplement en une surface interne pour laquelle les liaisons atomiques « parfaites » seront formées. Energétiquement parlant, ceci ne sera possible que si l'énergie libérée à la coalescence par formation d'une « surface interne » est supérieure à l'énergie qu'il faut dépenser pour que les plots 1000a-1000e eux-mêmes se déforment pour absorber les désorientations initiales entre les cristallites 510a-510b adjacentes. Le fait que le plot sous-jacent soit un piédestal en SiO2 est favorable puisque le SiO2 flue à la température de croissance. Le SiO2 est un matériau effectivement bien adapté pour ce procédé, mais ceci n'exclue pas l'utilisation de matériaux autres, tels que des verres qui peuvent fluer à des températures équivalentes ou plus basses, comme les verres en borosilicates ou les verres en borophosphosilicates (BPSG), utilisés également pour la fabrication du SOI.

Dans le cas des cristallites de GaN de forme hypothétiquement cubique et de 500 nm de côté, portées par des plots de section circulaire de diamètre 100 nm, l'énergie libérée à la coalescence peut s'exprimer comme la différence entre l'énergie de cohésion interne et les énergies de surface des deux surfaces qui seront mises en contact. Les valeurs d'énergie de surface sont de l'ordre de 0.1 à 0.2 eV/Angström$^2$ (on pourra pour cela se référer à la publication suivante : C. E.Dreyer, A. Janotti, and C. G. Van de Walle "Absolute surface energies of polar and nonpolar planes of GaN", PHYSICAL REVIEW B 89, 081305(R) 2014). Les énergies de cohésion sont quant à elles de l'ordre de 11eV (liaison Ga-N).

En première approximation, en partant d'une surface hexagonale (type 0001) on obtient une valeur de 36 eV par maille (trois liaisons Ga-N par maille), soit, pour la maille hexagonale considérée (surface 26 A$^2$), une énergie de

cohésion rapportée à la surface de 1.35eV / Angstrom². Nous avons simplifié l'approche en considérant des surfaces à mettre en contact de type c (0001), mais les corrections liées à l'orientation cristalline de ces surfaces (nombre de liaisons par maille et énergies de surface) sont du deuxième ordre et ne modifient que peu cette évaluation numérique.

On trouve alors une énergie « libérée » (état final - état initial) à la mise en contact par formation de liaisons covalentes de 1.35-0.3 = 1.05, soit environ 1eV par Angstrom². Ceci est évidemment indépendant de la désorientation entre les cristallites 510 à mettre en contact. Si l'on considère des cristallites de forme cubique (pour simplifier l'estimation comme sur les schémas en figure 2b) et de côté 500 nm, on trouve alors une énergie libérée de 25 $10^E6 \times 1,6$ $10^{E}$-19, soit de l'ordre de 4 $10^{E}$-12 Joules. Ceci est à comparer à l'énergie nécessaire pour déformer les plots 1000a-1000e en SiO2 sous les cristallites comme nous allons le détailler ci-dessous.

A la température d'épitaxie du GaN (environ 1100°C), l'oxyde de silicium a un comportement visco-plastique avec une viscosité qui dépend à la fois de la température et de la contrainte mécanique subie par le matériau.

Lorsque la température augmente, la viscosité du SiO2 diminue, comme tout matériau ayant une transition vitreuse. Au-dessus d'une certaine contrainte, la viscosité du SiO2 diminue aussi lorsque la contrainte mécanique augmente. Autrement dit, contrairement à un fluide classique dans lequel la vitesse de déformation plastique est proportionnelle aux contraintes de cisaillement (viscosité indépendante de la contrainte), au-delà d'une valeur seuil qu'on appelle contrainte de rupture, la vitesse de déformation du SiO2 augmente exponentiellement avec la contrainte. En pratique, à 1100°C, la contrainte de rupture du SiO2 est de l'ordre de 500 MPa : à cette température, la viscosité du SiO2 est donc indépendante de la contrainte jusqu'à des contraintes de 500MPa. Au-delà, la viscosité chute de plusieurs ordres de grandeur et une déformation plastique très rapide laisse ensuite une contrainte résiduelle proche de la contrainte de rupture. Cette contrainte résiduelle diminue ensuite beaucoup plus lentement par fluage classique (plusieurs minutes à plusieurs heures).

Avant alignement, les cristallites 510 de GaN présentent une désorientation les unes par rapport aux autres d'en moyenne 1 à 6°. Avant que les cristallites voisines ne se soudent en formant des liaisons atomiques covalentes, les forces interatomiques agissant entre les cristallites sont les forces de Van der Waals qui sont attractives à très courte portée. Ceci se traduit par l'existence d'un couple de rotation appliqué au point de contact pour les aligner. Après une très faible rotation d'une fraction de degré, la contrainte de rupture de 500MPa est atteinte dans le tronçon de fluage 220a-220e sous les plots 1000a-1000e. Le fluage devient alors quasiment instantané dans l'oxyde et le couple de rotation nécessaire à la rotation est constant pendant la fin de la phase d'alignement.

Si l'on reprend la géométrie de la figure 2b, i.e. une cristallite 510a-510b de forme cubique de 500nm de côté et centrée sur un plot 1000a-1000b de section circulaire plus petit de 100nm de côté. La coalescence complète des cristallites 510 est effectuée en typiquement quelques centaines de secondes. Si nous prenons 1s comme temps caractéristique de la mise en contact des cristallites 510, un modèle numérique montre que pour tourner le plot de 2° en une seconde environ, il faut fournir un travail mécanique de l'ordre de 0.5$^E$-20 à 1$^E$-20 Joules, en tenant compte de la rupture de l'oxyde à haute température. L'énergie libérée par la mise en contact des deux surfaces, de l'ordre de 10$^E$-11 à 10$^E$-13 Joules est donc très nettement supérieure à l'énergie mécanique de déformation de plots 1000a-1000e sous-jacents. Cette énergie est aussi plusieurs ordres de grandeur plus faible que celle qui aurait été nécessaire pour aligner des plots construits sur du silicium massif (bulk) ou pour aligner des plots formés par un matériau ne présentant pas de phase de transition vitreuse aux alentours de la température de croissance épitaxiale des cristallites 510.

Les considérations des paragraphes ci-dessus montrent que pour obtenir une coalescence des cristallites sans dislocation, on peut ajuster les paramètres suivants :

- Les propriétés de « rupture mécanique » du matériau formant le tronçon de fluage à haute température sous des contraintes relativement faibles de 500MPa.
- La taille suffisamment petite du plot 1000a-1000b de support comparée à la distance D entre les plots, permet de créer une contrainte dans le tronçon de fluage qui soit, pour un couple de rotation donné, supérieure à la contrainte de rupture.

Par ailleurs, comme indiqué ci-dessus, on veillera à ce que la température d'épitaxie $T_{épitaxie}$ rende possible le fluage du tronçon de fluage 220a-220b. En pratique, $T_{épitaxie} \geq 600°C$ (dans le cadre d'une épitaxie par jets moléculaires), $T_{épitaxie} \geq 900°C$ et de préférence $T_{épitaxie} \geq 1000°C$ et de préférence $T_{épitaxie} \geq 1100°C$. Ces valeurs permettent de réduire de manière particulièrement efficace les défauts dans la couche épitaxiée lorsque la couche de fluage est en SiO2. En pratique, $T_{épitaxie} \leq 1500°C$

Afin de faciliter la formation de joints de coalescence 560 sans dislocation, il sera préférable d'appliquer les conditions suivantes :

$$T_{épitaxie} \geq k1 . T_{transition\ vitreuse}, \text{ avec } k1 = 0.8, \text{ de préférence } k1 = 1 \text{ et de préférence } k1 = 1,5.$$

Selon un exemple de réalisation, $T_{épitaxie} \leq k2. T_{fusion\ min}$, $T_{fusion\ min}$ étant la température de fusion la plus faible parmi les températures de fusion des tronçons formant le plot. Il s'agit principalement du tronçon cristallin et du tronçon de fluage. Selon un exemple de réalisation, k2 = 0.9. Cela permet d'éviter une diffusion des espèces du matériau dont la température de fusion est la plus faible.

Ainsi, dans le cas où le plot est formé de tronçons de fluage en SiO2 et de tronçons cristallins en silicium, $T_{épitaxie} \leq 1296°C$. En effet, $T_{fusion\ min}$ est égale à la température de fusion du silicium puisque la température de fusion du silicium est égale à 1440° et la température de fusion du SiO2 est égale à 1970°C.

Selon un exemple de réalisation, la hauteur $e_{220}$ du tronçon de fluage est telle que e220 $\geq$ 0.017 $d_{plot}$. De préférence, e220 $\geq$ 0.05 $d_{plot}$. De préférence, e220 $\geq$ 0.1 $d_{plot}$. De préférence, e220 $\geq$ 1 $d_{plot}$. Ces valeurs, permettent d'obtenir une déformation suffisante pour réduire les contraintes au niveau du joint de grain.

Les plots 1000a-1000e présentent une hauteur $H_{plot}$, et deux plots 1000a-1000e adjacents sont distants d'une distance D, telle que : $H_{plot}/ D < 2$ et de préférence $H_{plot} / D \leq 1$.

Avantageusement, l'étape de formation des plots 1000a-1000e est effectuée de sorte que $d_{cristallite}/ d_{plot} \geq k3$, $d_{plot}$ étant la dimension maximale de la section du plot 1000a-1000e prise dans une direction parallèle à un plan principal dans lequel s'étend le substrat 100. $d_{cristallite}$ correspondant à la dimension de la cristallite mesurée selon la même direction que $d_{plot}$ au moment de la coalescence des cristallites 510a-510e.

Selon un exemple 100$\geq$ k3 $\geq$ 1.1. De préférence, 50$\geq$ k3 $\geq$ 1.5. De préférence, 5$\geq$ k3 $\geq$ 2.

Selon un exemple k3 $\geq$ 3, de préférence 100$\geq$ k3 $\geq$ 3. De préférence, 50$\geq$ k3 $\geq$ 3. De préférence, 5$\geq$ k3 $\geq$ 3.

Cette caractéristique permet aux tronçons de fluage de se déformer pour encaisser de manière particulièrement efficace les contraintes mécaniques qui naissent lorsque deux cristallites adjacentes commencent à coalescer. Ainsi, cette caractéristique contribue efficacement à réduire la densité de défauts au sein de la couche de nitrure que l'on obtient au final.

## Exemples de réalisation

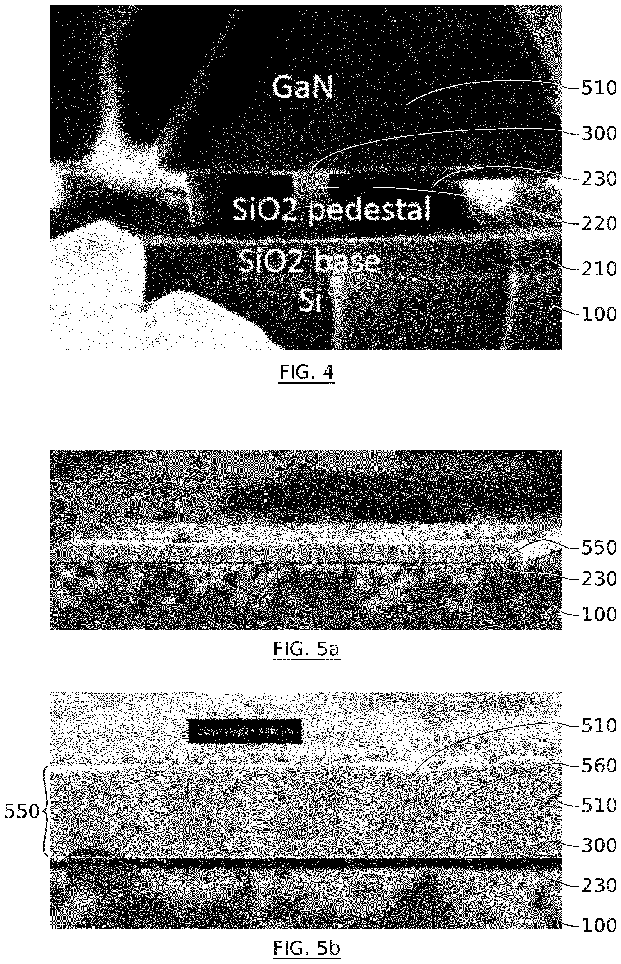

La **figure 4** est une photo prise au microscope électronique à balayage (MEB). Elle permet d'apercevoir un empilement comprenant successivement le substrat 100, la portion 210 de la couche de fluage non gravée, le tronçon de fluage 220, la couche cristalline 300 ainsi qu'une cristallite 510, ici de GaN. Cette cristallite 510 est de forme pyramidale en raison de la plus faible vitesse de croissance des plans semi-polaires qui forment les facettes de la pyramide. Dans cet exemple, la taille du plot est de 100 nm.

De part et d'autre du tronçon de fluage 220 on aperçoit des espaces 230 vides.

Pour assurer la coalescence des pyramides et obtenir une croissance bi-dimensionnelle, il peut être avantageux de procéder de la manière suivante. Au cours d'une première étape on réalise des pyramides sur chacun des nano-plots 1000a-1000e en utilisant des conditions de croissance données jusqu'à ce que les pyramides se jouxtent. Au cours d'une seconde étape, on modifie ces conditions de croissance pour induire une croissance latérale. Cette procédure de croissance en deux étapes est par exemple décrite dans la publication suivante : Shields et Al. 2011, Nanopendeo coalescence overgrowth of GaN on etched nanorod array Phys. Status Solidi C 8, No. 7-8, 2334-2336 (2011).

Les figures **5a et 5b** donnent des exemples d'une couche 550 obtenue selon ce procédé pour une matrice de 40x50 plots. Dans cet exemple, la taille des plots est de 500 nm et leur pas est de 1 $\mu$m. Cette dimension de plot permet de réduire très significativement le nombre de dislocations apparaissant sur la cristallite d'un plot. Par ailleurs, cette taille de plot permet d'optimiser la déformation et la transmission du couple lors de la coalescence.

De manière particulièrement avantageuse, on observe clairement que la couche 550 s'est désolidarisée du substrat 100 sous-jacent. La délamination de la couche 550 que l'on souhaite obtenir au final est donc particulièrement aisée. Cette délamination automatique peut être complète ou partielle. Elle sera décrite plus en détail par la suite.

Il est ainsi possible de réaliser des plaques (ou templates ou plateformes) auto-supportées de GaN, dans cet exemple de taille 40x50 $\mu$m.

Il est notamment possible d'adapter le nombre de plots et la période pour que la dimension de ces plaques soit compatible avec la fabrication de diodes à des dimensions spécifiques et qui pourront être très facilement reportées sur tout type de support (conducteur électrique / thermique / réflecteur optique...).

Sur ces figures **5a et 5b,** on remarque également que les joints de coalescence 560 se forment sans dislocation et qu'aucune dislocation n'est présente au niveau des cristallites 510.

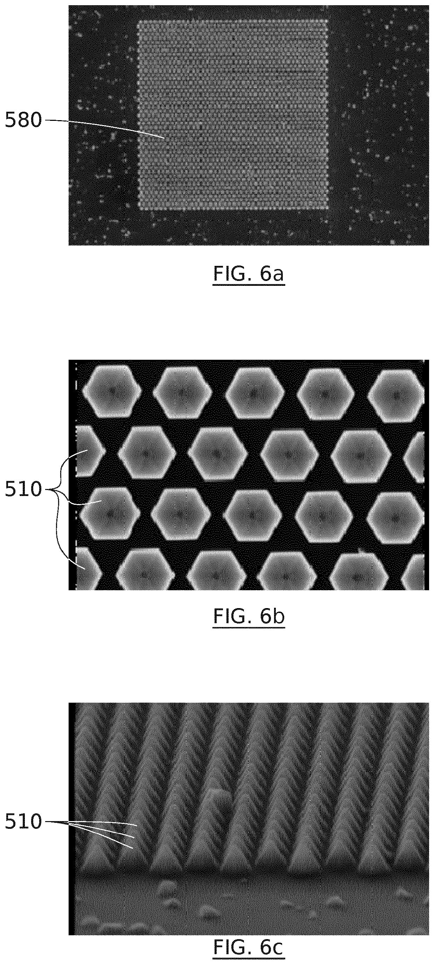

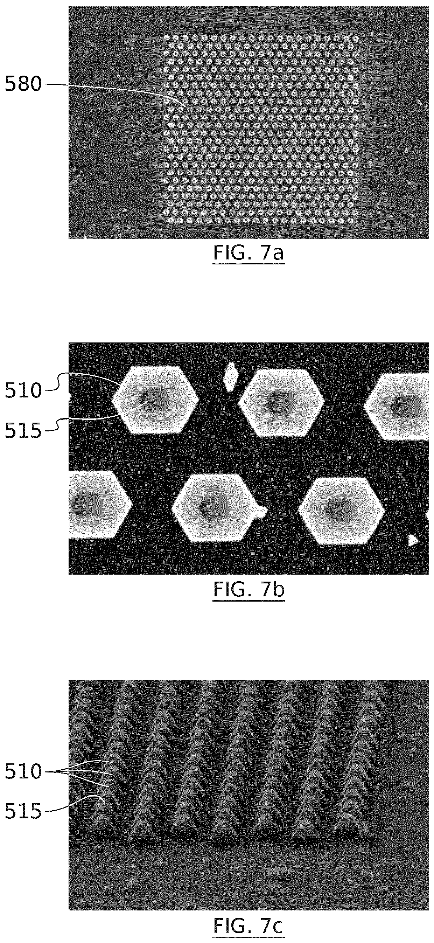

Les figures **6a à 6c** et **7a à 7c** sont des photos représentant des matrices 580 de cristallites 510 de GaN formant des pyramides et obtenues après croissance sur les plots. Les plots ont été réalisés par lithographie par faisceau d'électron (e-beam) à partir d'un empilement comprenant les couches suivantes :

- couche de fluage 200 : SiO2
- couche cristalline 300 : Si
- couche-tampon 400 : AlN

- couche d'amorçage 500 : GaN

Sur l'exemple illustré en figures 6a à 6c, les plots ont un diamètre de 200 nm et sont espacés de 1μm. Sur l'exemple illustré en figures 7a à 7c, les plots ont un diamètre de 500 nm et sont espacés de 2μm. Le sommet des cristallites 510 est plat sur cet exemple. Ce sommet est référencé 515 sur les figures.

### Caractérisations des défauts de coalescence

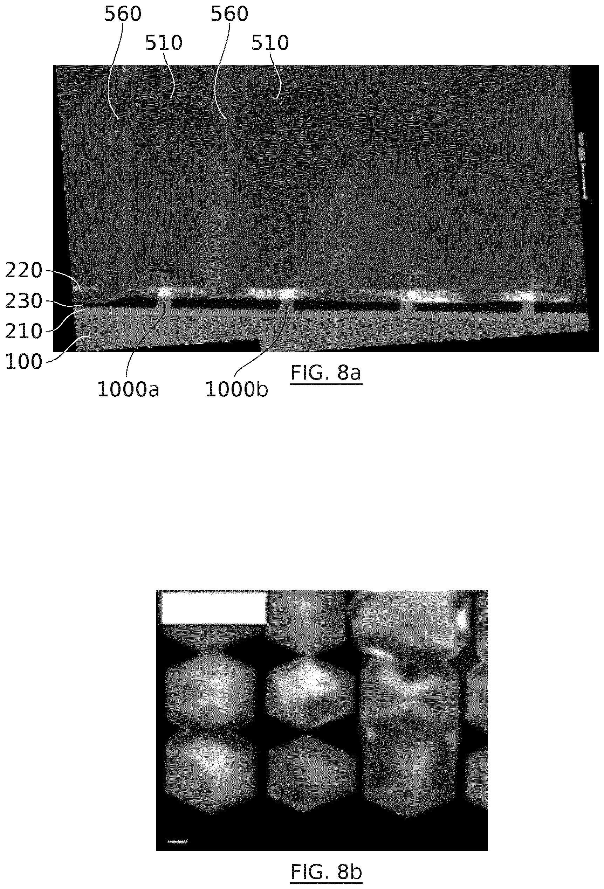

La **figure 8a** est une photo prise au microscope électronique en transmission (TEM) d'une coupe de cristaux 510 de GaN ayant coalescé. Sur cette figure, on remarque tout d'abord que la majeure partie des dislocations 561 issues de la re-croissance sont alignées dans le plan de croissance au démarrage de la croissance.

Par ailleurs il apparaît clairement que la coalescence des cristallites 510 issues de plots adjacents se fait avec très peu de défauts de coalescence au niveau du joint de coalescence 560. Ceci est à comparer aux méthodes classiques pour lesquelles la coalescence génère des défauts traversants, que ces méthodes classiques soient basées sur une recroissance latérale illustrée en figure 9 et comme décrit dans la publication E.B Yakimov et A.Y Polyakov, 2015 Ebic investigation of dislocations in ELOG GaN, Phys. Status Solidi, ou qu'elles soient basées sur une recroissance de type pendeo à partir de structures unidimensionnelles comme décrit dans la publication mentionnée ci-dessus Shields et Al. 2011, Nanopendeo coalescence overgrowth of GaN on etched nanorod array Phys. Status Solidi C 8, No. 7-8, 2334-2336 (2011).

On remarque également en figure 8a que les plots 1000a-1000e, à la moitié de leur hauteur, sont fendus, ce qui permettra une délamination facile de la couche épitaxiée 550 sur les matrices 580 de 1000a-1000e, pour en faire des templates ou pseudo-substrats pour la recroissance ultérieure de couches actives, comme expliqué ci-dessus.

Une interprétation possible est que cette fissuration des plots 1000a-1000e est due à la déformation plastique (sous l'effet des contraintes de torsion des plots1000a-1000e) à la mise en coalescence des cristallites 510 et ce à la température de croissance épitaxiale. Comme indiqué ci-dessus, ce découplage de la couche épitaxiée 550 par rapport au substrat 100 lors de la croissance est un atout considérable puisque aucune courbure des plaques ainsi formées n'est possible au refroidissement.

La **figure 8b** confirme l'absence de défauts à la coalescence entre deux cristaux, par exemple de forme pyramidale, en utilisant la technique de cathodoluminescence. Cette technique permet de réaliser une cartographie spatiale de l'émission de photons par le matériau considéré. L'image de cathodoluminescence panchromatique en figure 8b montre que, aux variations d'émission près liées à l'extraction de lumière issue des facettes différentes (ou des arrêtes), il n'y a pas au niveau du raccordement entre deux cristaux, des recombinaisons non radiatives, ce qui témoigne de l'absence de défauts de structure dans la région du joint de coalescence.

Au vu de la description qui précède, il apparaît clairement que la présente invention propose une solution particulièrement efficace pour réduire la densité de défauts dans une couche de nitrure épitaxiée, en particulier à partir de plots gravés dans un empilement de type SOI.

L'invention n'est pas limitée aux modes de réalisation décrits ci-dessus et s'étend à tous les modes de réalisation couverts par les revendications.

### Revendications

1. Procédé d'obtention d'une couche de nitrure (N) (550) obtenue de préférence à partir d'au moins l'un parmi le gallium (Ga), l'indium (In) et l'aluminium (Al), **caractérisé en ce que** le procédé comprend les étapes suivantes :

   - fournir un empilement comprenant un substrat (100) et au moins les couches suivantes successivement disposées depuis le substrat (100) :

      ▪ une première couche, dite couche de fluage (200), faite en un matériau présentant une température de transition vitreuse, la couche de fluage (200) présentant une température de transition vitreuse $T_{\text{transition vitreuse}}$,
      ▪ une deuxième couche, cristalline, dite couche cristalline (300), différente de la couche de fluage (220),

   - former des plots (1000a-1000e) par gravure au moins de la couche cristalline (300) et d'au moins une portion (220) de la couche de fluage (200) de manière à ce que :

      o chaque plot (1000a-1000e) comporte au moins :

- un premier tronçon, dit tronçon de fluage (220a, 220b), formé par une portion au moins de la couche de fluage (200),
  - un deuxième tronçon, cristallin, dit tronçon cristallin (300a, 300b), formé par la couche cristalline (300) et surmontant le tronçon de fluage (220a, 220b),

o chaque plot (1000a-1000e) présente une section dont la dimension maximale est comprise entre 10 et 500 nm ($10^{-9}$ mètres),

- faire croitre par épitaxie une cristallite (510a-510e) sur certains au moins desdits plots (1000a-1000e) et poursuivre la croissance épitaxiale des cristallites (510a-510e) au moins jusqu'à coalescence des cristallites (510a-510e) portées par deux plots (1000a-1000e) adjacents, de manière à former ladite couche de nitrure (550), la croissance épitaxiale étant effectuée à une température $T_{\text{épitaxie}}$, telle que :

$$T_{\text{épitaxie}} \geq k1 . T_{\text{transition vitreuse}}, \text{ avec } k1 \geq 0,8.$$

2. Procédé selon la revendication précédente, dans lequel la couche de fluage (200) est faite d'un matériau pris parmi :

- un oxyde de silicium SixOy, x et y étant des entiers, et de préférence la couche de fluage est en SiO2,
- un verre,
- un verre en borosilicate,
- un verre en borophosphosilicate (BPSG).

3. Procédé selon l'une quelconque des revendications précédentes, dans lequel $k1 \geq 1$, et de préférence $k1 \geq 1,5$.

4. Procédé selon l'une quelconque des revendications précédentes, dans lequel $T_{\text{épitaxie}} \leq k2 * T_{\text{fusion min}}$, $T_{\text{fusion min}}$ étant la température de fusion la plus faible parmi les températures de fusion des tronçons formant le plot, avec $k2 \leq 0,9$ et de préférence $k2 \leq 0,8$.

5. Procédé selon l'une quelconque des revendications précédentes, dans lequel les plots (1000a-1000e) comprennent au moins une couche tampon (400) surmontant la couche cristalline (300), et faite en un matériau différent de celui de ladite couche de nitrure (550), et dans lequel de préférence ladite couche de nitrure (550) est une couche de nitrure de gallium (GaN) et la couche tampon (400) est en nitrure d'aluminium (AlN), la couche tampon (400) étant de préférence formée par dépôt par épitaxie au-dessus de la couche cristalline (300), avant l'étape de formation des plots (1000a-1000e) par gravure.

6. Procédé selon l'une quelconque des revendications précédentes, dans lequel l'empilement comprend, avant ladite étape de formation des plots (1000a-1000e) par gravure, au moins une couche d'amorçage (500), surmontant ladite couche cristalline (300), la couche d'amorçage (500) étant faite du même matériau que ladite couche de nitrure (550).

7. Procédé selon l'une quelconque des revendications précédentes, dans lequel fournir ledit empilement comprend fournir un substrat élaboré de type silicium sur isolant (SOI) comprenant un substrat (100) de base surmontée successivement d'une couche d'oxyde formant ladite couche de fluage (200) et d'une couche semi conductrice formant ladite couche cristalline (300).

8. Procédé selon l'une quelconque des revendications précédentes, dans lequel le tronçon de fluage (220) présente une hauteur $e_{220}$ telle que $e_{220} \geq 0.1*d_{\text{plot}}$, $d_{\text{plot}}$ étant le diamètre du plot (1000a-1000e) ou plus généralement la distance bord à bord du plot (1000a-1000e) prise, au niveau du tronçon de fluage (220) et dans une direction parallèle à un plan principal dans lequel s'étend le substrat (100), de préférence $e_{220} \geq 1*d_{\text{plot}}$.

9. Procédé selon l'une quelconque des revendications précédentes, dans lequel les plots (1000a-1000e) présentent une hauteur $H_{\text{plot}}$, et dans lequel deux plots (1000a-1000e) adjacents sont distants d'une distance D, telle que :

$$H_{\text{plot}} / D < 2 \text{ et de préférence } H_{\text{plot}} / D \leq 1.$$

10. Procédé selon l'une quelconque des revendications précédentes, dans lequel la couche cristalline (300) est à base de l'un parmi le silicium le SiC et l'$Al_2O_3$.

**11.** Procédé selon l'une quelconque des revendications précédentes, dans lequel l'étape de formation des plots (1000a-1000e) comprend la gravure de la couche cristalline (300) et la gravure d'une portion (220) seulement de la couche de fluage (200) de manière à conserver une portion (210) de la couche de fluage (200) entre les plots (1000a-1000e).

**12.** Procédé selon l'une quelconque des revendications précédentes, dans lequel l'étape de formation des plots (1000a-1000e) est effectuée de sorte que $d_{cristallite}$ / $d_{plot}$ $\geq$ k3, avec k3=3, $d_{plot}$ étant la dimension maximale de la section du plot (1000a-1000e) prise dans une direction parallèle à un plan principal dans lequel s'étend le substrat (100), $d_{cristallite}$ correspondant à la dimension de la cristallite mesurée selon la même direction que $d_{plot}$ au moment de la coalescence des cristallites (510a-510e).

**13.** Procédé selon l'une quelconque des revendications précédentes, dans lequel chaque plot (1000a-1000e) présente une face supérieure et dans lequel la croissance par épitaxie des cristallites (510a-510e) s'effectue en partie au moins et de préférence uniquement à partir de ladite face supérieure.

**14.** Dispositif microélectronique comprenant un substrat (100) surmontée d'une pluralité de plots (1000a- 1000e) **caractérisé en ce que** :

chaque plot (1000a- 1000e) comprend au moins :

- un premier tronçon, dit tronçon de fluage (220a, 220b), présentant une température de transition vitreuse $T_{transition}$ vitreuse,
- un deuxième tronçon, dit tronçon cristallin (300a, 300b) formé d'un matériau cristallin, le tronçon de fluage (220a, 220b) et le tronçon cristallin (300a, 300b) étant successivement disposés depuis le substrat (100),

**en ce que** le dispositif comprend également une couche continue de nitrure (N) (550) obtenue de préférence à partir d'au moins l'un parmi le gallium (Ga), l'indium (In) et l'aluminium (Al), ladite couche (550) étant entièrement supportée par les plots (1000a-1000e),
et **en ce que** le matériau du tronçon de fluage (220a, 220b) et le matériau de ladite couche de nitrure (550) sont choisis de manière à ce que:

$$T_{épitaxie} \geq k1 . T_{transition\ vitreuse},\ \text{avec k1=0.8,}$$

$T_{épitaxie}$ étant la température minimale permettant la formation par épitaxie de la couche de nitrure (550).

**15.** Diodes électroluminescentes (LED) comprenant au moins un dispositif microélectronique selon la revendication précédente.

**Patentansprüche**

**1.** Verfahren zur Herstellung einer Nitridschicht (N) (550), die vorzugsweise ausgehend von wenigstens einem aus Gallium (Ga), Indium (In) und Aluminium (Al) hergestellt wird, **dadurch gekennzeichnet, dass** das Verfahren folgende Schritte umfasst:

- Bereitstellen eines Stapels, umfassend ein Substrat (100) und wenigstens folgende Schichten, die nacheinander von dem Substrat (100) ausgehend angeordnet sind:

▪ eine erste Schicht, so genannte Kriechschicht (200), die aus einem Material gefertigt ist, das eine Glasübergangstemperatur aufweist, wobei die Kriechschicht (200) eine Glasübergangstemperatur $T_{Glasübergang}$ aufweist,
▪ eine zweite, kristalline Schicht, so genannte Kristallschicht (300), die von der Kriechschicht (220) verschieden ist,

- Bilden von Kontakten (1000a-1000e) durch Ätzen wenigstens der Kristallschicht (300) und wenigstens eines Abschnitts (220) der Kriechschicht (200), sodass:

o jeder Kontakt (1000a-1000e) wenigstens umfasst:

■ ein erstes Teilstück, so genanntes Kriechteilstück (220a, 220b), das von einem Abschnitt wenigstens der Kriechschicht (200) gebildet wird,
■ ein zweites, kristallines Teilstück, so genanntes Kristallteilstück (300a, 300b), das von der Kristallschicht (300) gebildet wird und das Kriechteilstück (220a, 220b) überragt,

o jeder Kontakt (1000a-1000e) einen Querschnitt aufweist, dessen maximale Abmessung zwischen 10 und 500 nm ($10^{-9}$ Meter) beträgt,

- Wachsenlassen eines Kristallits (510a-510e) durch Epitaxie auf wenigstens manchen der Kontakte (1000a-1000e) und Fortsetzen des epitaxialen Wachstums der Kristalliten (510a-510e) wenigstens bis zur Koaleszenz der Kristalliten (510a-510e), die von zwei benachbarten Kontakten (1000a-1000e) getragen werden, um die Nitridschicht (550) zu bilden, wobei das epitaxiale Wachstum bei einer Temperatur $T_{Epitaxie}$ erfolgt, wie etwa:

$$T_{Epitaxie} \geq k1.T_{Glasübergang}, \text{ mit } k1 \geq 0,8.$$

2. Verfahren nach dem vorstehenden Anspruch, wobei die Kriechschicht (200) aus einem Material gefertigt ist, das genommen wird aus:

- einem Siliziumoxid SixOy, wobei x und y ganze Zahlen sind und vorzugsweise die Kriechschicht aus SiO2 ist,
- einem Glas,
- einem Borsilikatglas,
- einem Bor-Phosphor-Silikatglas (BPSG).

3. Verfahren nach einem der vorstehenden Ansprüche, wobei $k1 \geq 1$ und vorzugsweise $k1 \geq 1,5$.

4. Verfahren nach einem der vorstehenden Ansprüche, wobei $T_{Epitaxie} \leq k2*T_{Schmelz\ min}$, wobei $T_{Schmelz\ min}$ die geringste Schmelztemperatur unter den Schmelztemperaturen der Teilstücke ist, welche den Kontakt bilden, mit $k2 \leq 0,9$ und vorzugsweise $k2 \leq 0,8$.

5. Verfahren nach einem der vorstehenden Ansprüche, wobei die Kontakte (1000a-1000e) wenigstens eine Pufferschicht (400) umfassen, welche die Kristallschicht (300) überragt und die aus einem Material gefertigt ist, das von jenem der Nitridschicht (550) verschieden ist, und wobei vorzugsweise die Nitridschicht (550) eine Galliumnitridschicht (GaN) ist und die Pufferschicht (400) aus Aluminiumnitrid (AlN) ist, wobei die Pufferschicht (400) vorzugsweise durch Ablagerung mittels Epitaxie über der Kristallschicht (300) gebildet wird, vor dem Schritt des Bildens der Kontakte (1000a-1000e) durch Ätzen.

6. Verfahren nach einem der vorstehenden Ansprüche, wobei der Stapel, vor dem Schritt des Bildens der Kontakte (1000a-1000e) durch Ätzen, wenigstens eine Grundierschicht (500) umfasst, welche die Kristallschicht (300) überragt, wobei die Grundierschicht (500) aus dem gleichen Material gefertigt ist wie die Nitridschicht (550).

7. Verfahren nach einem der vorstehenden Ansprüche, wobei das Bereitstellen des Stapels das Bereitstellen eines Substrats umfasst, das in der Art von Silizium auf einem Isolator (SOI) hergestellt ist, umfassend ein Grundsubstrat (100), das nacheinander von einer Oxidschicht, welche die Kriechschicht (200) bildet, und von einer Halbleiterschicht, welche die Kristallschicht (300) bildet, überragt wird.

8. Verfahren nach einem der vorstehenden Ansprüche, wobei das Kriechteilstück (220) eine Höhe $e_{220}$ aufweist, wie etwa $e_{220} \geq 0.1*d_{Kontakt}$, wobei $d_{Kontakt}$ der Durchmesser des Kontakts (1000a-1000e) oder noch allgemeiner der Abstand von Kante zu Kante des Kontakts (1000a-1000e) ist, der auf Höhe des Kriechteilstücks (220) und in einer Richtung parallel zu einer Hauptebene genommen wird, in der sich das Substrat (100) erstreckt, vorzugsweise $e_{220} \geq 1*d_{Kontakt}$.

9. Verfahren nach einem der vorstehenden Ansprüche, wobei die Kontakte (1000a-1000e) eine Höhe $H_{Kontakt}$ aufweisen und wobei zwei benachbarte Kontakte (1000a-1000e) in einem Abstand D voneinander beabstandet sind, wie etwa:

$$H_{Kontakt}/D < 2 \text{ und vorzugsweise } H_{Kontakt}/D \leq 1.$$

**10.** Verfahren nach einem der vorstehenden Ansprüche, wobei die Kristallschicht (300) auf Basis von einem aus Silizium, SiC und $Al_2O_3$ hergestellt ist.

**11.** Verfahren nach einem der vorstehenden Ansprüche, wobei der Schritt des Bildens der Kontakte (1000a-1000e) das Ätzen der Kristallschicht (300) und das Ätzen nur eines Abschnitts (220) der Kriechschicht (200) umfasst, um einen Abschnitt (210) der Kriechschicht (200) zwischen den Kontakten (1000a-1000e) zu bewahren.

**12.** Verfahren nach einem der vorstehenden Ansprüche, wobei der Schritt des Bildens der Kontakte (1000a-1000e) so erfolgt, dass $d_{Kristallit}/d_{Kontakt} \geq k3$, mit k3=3, wobei $d_{Kontakt}$ die maximale Abmessung des Querschnitts des Kontakts (1000a-1000e) ist, die in einer Richtung parallel zu einer Hauptebene genommen wird, in der sich das Substrat (100) erstreckt, wobei $d_{Kristallit}$ der Abmessung des Kristallits entspricht, gemessen gemäß der gleichen Richtung wie $d_{Kontakt}$ zum Zeitpunkt der Koaleszenz der Kristalliten (510a-510e).

**13.** Verfahren nach einem der vorstehenden Ansprüche, wobei jeder Kontakt (1000a-1000e) eine obere Fläche aufweist und wobei das Wachstum mittels Epitaxie der Kristalliten (510a-510e) wenigstens teilweise und vorzugsweise ausschließlich ausgehend von der oberen Fläche erfolgt.

**14.** Mikroelektronische Vorrichtung, umfassend ein Substrat (100), das von einer Vielzahl von Kontakten (1000a-1000e) überragt wird, **dadurch gekennzeichnet, dass**:

jeder Kontakt (1000a-1000e) wenigstens umfasst:

- ein erstes Teilstück, so genanntes Kriechteilstück (220a, 220b), das eine Glasübergangstemperatur $T_{Glasübergang}$ aufweist,
- ein zweites Teilstück, so genanntes Kristallteilstück (300a, 300b), das von einem kristallinen Material gebildet wird, wobei das Kriechteilstück (220a, 220b) und das Kristallteilstück (300a, 300b) nacheinander von dem Substrat (100) ausgehend angeordnet sind,

dadurch, dass die Vorrichtung ebenfalls eine kontinuierliche Nitridschicht (N) (550) umfasst, die vorzugsweise ausgehend von wenigstens einem aus Gallium (Ga), Indium (In) und Aluminium (Al) hergestellt wird, wobei die Schicht (550) zur Gänze von den Kontakten (1000a-1000e) gestützt wird,
und dadurch, dass das Material des Kriechteilstücks (220a, 220b) und das Material der Nitridschicht (550) so gewählt werden, dass:

$$T_{Epitaxie} \geq k1.T_{Glasübergang}, \text{ mit } k1=0,8,$$

wobei $T_{Epitaxie}$ die Mindesttemperatur ist, welche die Bildung der Nitridschicht (550) mittels Epitaxie ermöglicht.

**15.** Leuchtdioden (LED), umfassend wenigstens eine mikroelektronische Vorrichtung nach dem vorstehenden Anspruch.

**Claims**

**1.** A process for obtaining a nitride (N) layer (550) preferably obtained from at least one of gallium (Ga), indium (In) and aluminium (Al), **characterised in that** the process comprises the following steps:

- providing a stack comprising a substrate (100) and at least the following layers which are successively disposed from the substrate (100):

  ▪ a first layer, called flow layer (200), made of a material having a glass transition temperature, the flow layer (200) having a glass transition temperature $T_{glass}$ transition
  ▪ a second layer, crystalline, called crystalline layer (300), which is different from the flow layer (220),

- forming pads (1000a-1000e) by etching at least the crystalline layer (300) and at least one portion (220) of the flow layer (200) so that:

o each pad (1000a-1000e) includes at least:

- one first segment, called flow segment (220a, 220b), formed by at least one portion of the flow layer (200),
- one second segment, crystalline, called crystalline segment (300a, 300b), formed by the crystalline layer (300) and surmounting the flow segment (220a, 220b),

o each pad (1000a-1000e) has a section whose maximum dimension is comprised between 10 and 500 nm ($10^{-9}$ metres),

- epitaxially growing a crystallite (510a-510e) on at least some of said pads (1000a-1000e) and continuing the epitaxial growth of the crystallites (510a-510e) at least until coalescence of the crystallites (510a-510e) carried by two adjacent pads (1000a-1000e), so as to form said nitride layer (550), the epitaxial growth being performed at a temperature $T_{epitaxy}$ such that:

$$T_{epitaxy} \geq k1 . T_{glass\ transition}, \text{ with } k1 \geq 0.8.$$

2. The process according to the preceding claim, wherein the flow layer (200) is made of a material selected from:

- a silicon oxide SixOy, x and y being integers, and the flow layer is preferably made of SiO2,
- a glass,
- a borosilicate glass,
- a borophosphosilicate glass (BPSG).

3. The process according to any one of the preceding claims, wherein $k1 \geq 1$, and preferably $k1 \geq 1.5$.

4. The process according to any one of the preceding claims, wherein $T_{epitaxy} \leq k2 * T_{melting\ min}$, $T_{melting\ min}$ being the lowest melting temperature among the melting temperatures of the segments forming the pad, with $k2 \leq 0.9$ and preferably $k2 \leq 0.8$.

5. The process according to any one of the preceding claims, wherein the pads (1000a-1000e) comprise at least one buffer layer (400) surmounting the crystalline layer (300), and made of a material which is different from that of said nitride layer (550), and wherein preferably said nitride layer (550) is a gallium nitride (GaN) layer and the buffer layer (400) is made of aluminium nitride (AlN), the buffer layer (400) being preferably formed by epitaxial deposition above the crystalline layer (300), before the step of forming the pads (1000a-1000e) by etching.

6. The process according to any one of the preceding claims, wherein the stack comprises, before said step of forming the pads (1000a-1000e) by etching, at least one priming layer (500), surmounting said crystalline layer (300), the priming layer (500) being made of the same material as said nitride layer (550).

7. The process according to any one of the preceding claims, wherein providing said stack comprises providing an elaborate silicon-on-insulator (SOI) type substrate comprising a base substrate (100) successively surmounted by an oxide layer forming said flow layer (200) and by a semiconductor layer forming said crystalline layer (300).

8. The process according to any one of the preceding claims, wherein the flow segment (220) has a height $e_{220}$ such that $e_{220} \geq 0.1*d_{pad}$, $d_{pad}$ being the diameter of the pad (1000a-1000e) or more generally the edge-to-edge distance of the pad (1000a-1000e) taken, at the flow segment (220) and in a direction which is parallel to a main plane in which the substrate (100) extends, preferably $e_{220} \geq 1*d_{pad}$.

9. The process according to any one of the preceding claims, wherein the pads (1000a-1000e) have a height $H_{pad}$, and wherein two adjacent pads (1000a-1000e) are separated by a distance D, such that:

$$H_{pad} / D < 2 \text{ and preferably } H_{pad} / D \leq 1.$$

10. The process according to any one of the preceding claims, wherein the crystalline layer (300) is based on one of silicon, SiC and $Al_2O_3$.

11. The process according to any one of the preceding claims, wherein the step of forming the pads (1000a-1000e) comprises the etching of the crystalline layer (300) and the etching of only a portion (220) of the flow layer (200) so as to retain a portion (210) of the flow layer (200) between the pads (1000a-1000e).

12. The process according to any one of the preceding claims, wherein the step of forming the pads (1000a-1000e) is performed such that $d_{crystallite} / d_{pad} \geq k3$, with k3=3, $d_{pad}$ being the maximum dimension of the section of the pad (1000a-1000e) taken in a direction parallel to a main plane in which the substrate (100) extends, $d_{crystallite}$ corresponding to the dimension of the crystallite measured in the same direction as $d_{pad}$, at the time of the coalescence of the crystallites (510a-510e).

13. The process according to any one of the preceding claims, wherein each pad (1000a-1000e) has an upper face and wherein the epitaxial growth of the crystallites (510a-510e) is performed at least partially and preferably only from said upper face.

14. A microelectronic device comprising a substrate (100) surmounted by a plurality of pads (1000a- 1000e) **characterised in that**:

   each pad (1000a- 1000e) comprises at least:

   - one first segment, called flow segment (220a, 220b), having a glass transition temperature $T_{glass}$ transition,
   - one second segment, called crystalline segment (300a, 300b) formed of a crystalline material, the flow segment (220a, 220b) and the crystalline segment (300a, 300b) being successively disposed from the substrate (100),

   **in that** the device also comprises a continuous nitride (N) layer (550) preferably obtained from at least one of gallium (Ga), indium (In) and aluminium (Al), said layer (550) being entirely supported by the pads (1000a-1000e), and **in that** the material of the flow segment (220a, 220b) and the material of said nitride layer (550) are selected so that:

$$T_{epitaxy} \geq k1.\ T_{glass\ transition},\ \text{with } k1=0.8,$$

   $T_{epitaxy}$ being the minimum temperature allowing epitaxially forming the nitride layer (550).

15. Light-emitting diodes (LEDs) comprising at least one microelectronic device according to the preceding claim.

300
200
100

FIG. 1a

500
400
300
200
100

FIG. 1b

$H_{plot}$

$d_{plot}$  1000a    1000b    1000c    1000d    1000e

500
400
D
300
200
100

FIG. 1c

$H_{plot}$

510a    510b    510c    510d    510e

400a
300a    400b
220a    300b    220b
210a    220b    D    400
300
220
210    200
100

FIG. 1d

$e_{550}$    560    560

510a    510b    510c    510d    510e

550

400
300
$e_{220}$    200
$e_{210}$    100

FIG. 1e

FIG. 2a

FIG. 2b

EP 3 728 703 B1

FIG. 3a

FIG. 3b

22

GaN — 510
— 300
— 230
SiO2 pedestal — 220
SiO2 base — 210
Si — 100

FIG. 4

— 550
— 230
— 100

FIG. 5a

— 510
— 560
550 — 510
— 300
— 230
— 100

FIG. 5b

FIG. 6a

FIG. 6b

FIG. 6c

FIG. 7a

FIG. 7b

FIG. 7c

FIG. 8a

FIG. 8b

# EP 3 728 703 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **J.P.HIRTH ; J. LOTHE.** Theory of dislocations. John Wiley and sons, 1982

- **SHIELDS et al.** Nanopendeo coalescence overgrowth of GaN on etched nanorod array. *Phys. Status Solidi C,* 2011, vol. 8 (7-8), 2334-2336